# EUROPEAN PATENT APPLICATION

(11) **EP 2 618 383 A1**
(43) Date of publication of application: **24.07.2013**
(21) Application number: 11825052.1
(22) Date of filing: 07.09.2011
(51) Int. Cl.: H01L 31/042, B32B 9/00, B32B 27/18, B32B 27/28, B32B 27/30, C08J 7/04

(54) **BASE MATERIAL FOR SOLAR CELL MODULE AND METHOD FOR PRODUCING SAME**

(30) Priority: 13.09.2010 JP 2010204840
(71) Applicant: NHK Spring Co., Ltd., Yokohama-shi, Kanagawa 236-0004 (JP)
(72) Inventor: ICHIMURA, Shigeki, Yokohama-shi Kanagawa 236-0004 (JP); IWASA, Taketoshi, Yokohama-shi Kanagawa 236-0004 (JP)
(74) Representative: HOFFMANN EITLE
(86) International application number: PCT/JP2011/070396
(87) International publication number: WO 2012/036046

(57) **Abstract**

The base material for a solar cell module according to the present invention is a base material for a solar cell module consisting of a base material film including at least one layer and a coating layer including at least one layer and formed on one surface or both surfaces of the base material film, wherein the coating layer is a copolymer layer obtained by curing a liquid coating film consisting of an acrylic-based resin component A which consists of metal alkoxide having a reactive functional group (Y), an acrylic-based monomer having a reactive functional group (X) that reacts with the reactive functional group (Y), and an acrylic-based monomer without the reactive functional group (X); and an ethylene-based resin component B having a carboxyl group binding to the reactive functional group (Y) of metal alkoxide and including an ethylene monomer b1, a vinyl acetate monomer b2, and a monomer b3 of carboxylic acid vinyl esters other than vinyl acetate.

## Description

### Field

The present invention relates to a base material for a solar cell module that is suitable for use in a solar cell module in which a solar cell element is sealed with an aid of a sealant between two types of a base, that is, a transparent light receiving base and a rear surface protection base, and a method for producing the base material. More specifically, it relates to a base material for a solar cell module that has an excellent anti-weathering property, an excellent water resistant property, an excellent water vapor barrier property, flexibility that prevents deterioration of a water vapor gas barrier property even when the base is bent in a certain degree in an in-mold assembly molding process such as hot press molding and vacuum and pressure molding during manufacturing of a solar cell module, and adhesiveness to a sealant that is not suppressed even when a polyethylene sealant is used as a sealant, and a method for producing the base material for a solar cell module.

### Background

A solar cell module has, as basic elements, a solar cell element, a rear surface protection sheet supporting the solar cell element (a rear surface protection base), and a transparent base (such as a transparent glass plate or a transparent resin sheet) provided on the light receiving side of the solar cell element. In the solar cell module, the solar cell element is sealed between the rear surface protection sheet and the transparent light receiving base for protecting the solar cell element from the external environment in the solar cell module. This sealing structure is realized by forming a layered body and then giving a shape to the layered body by vacuum and pressure molding with application of heat, in which the layered body is formed by interposing a sealant sheet made of an ethylene vinyl acetate (EVA) resin between the transparent light receiving base and the solar cell element, and between the rear surface protection base and the solar cell element.

Several proposals have been conventionally made for a structure of a rear surface protection sheet included in a solar cell module. Accordingly, as a sheet with features for imparting a barrier property against gases such as water vapor or oxygen gas, a multilayered structure in which films having different properties are bonded with each other with an adhesive is mainly used.

For example, Patent Literature 1 discloses a structure using aluminum foil so as to ensure the gas barrier property. Patent Literature 2 discloses a structure in which a film having an oxide vapor deposited film provided on a surface thereof to ensure the gas barrier property is bonded to another film with an adhesive. Patent Literature 3 discloses a multilayered structure formed of a combination of an oxide vapor deposited film and a coating layer of a complex containing a hydrolysis product of a metal alkoxide and a water soluble polymer.

In the sheet as disclosed in Patent Literature 1, the aluminum foil is used and thus the sheet has an excellent gas barrier property. However, a resin film included in the sheet may be softened by heat of about 150°C applied by hot pressing for manufacturing a solar cell module. Accompanying such softening of a resin film layer, a projection of a solar cell element electrode may pass through the softened resin film layer. When such an incident occurs, the electrode comes into contact with the aluminum foil to cause a short circuit, thereby adversely affecting the cell performance.

The sheet using an inorganic oxide vapor deposited film as disclosed in Patent Literature 2 has poor flex resistance because the inorganic oxide vapor deposited film has a glassy film structure. Accordingly, there is a problem that mechanical stress on the film causes cracks which remarkably deteriorate the gas barrier property of the sheet. In this regard, it may be considered that the thickness of the vapor deposited film is reduced so as to have a certain level of flexibility in the sheet. However, when the film thickness is reduced, defects occur in the film, resulting in a lowered gas barrier property.

In the sheet as disclosed in Patent Literature 3, the gas barrier property is ensured by providing, on the inorganic oxide vapor deposited layer, the coating layer of the complex of a water soluble polymer such as polyvinyl alcohol (PVA) and one or more kinds of metal alkoxides and/or hydrolysis products thereof. However, in the sheet, polymer such as PVA has an insufficient water vapor barrier property. Additionally, the sheet is inevitably deteriorated by ultraviolet rays because the C-C bond of the main chain of the polymer is easily broken. Therefore the gas barrier property and the anti-weathering property of the polymer are not reliable in a long period of time unless the polymer is combined with an oxide vapor deposited film. In the sheet, forming of an oxide vapor deposited film on the surface of a base material film of the sheet requires large-scale equipment with a vacuum system. In addition, after the oxide vapor deposited film is formed, it is required to perform applying the complex of the water soluble polymer and the metal alkoxide(s) and/or the hydrolysis product(s) thereof, which increases the manufacturing steps. As a result, the sheet has a problem of high manufacturing costs.

In any of the aforementioned sheets, in order to impart an anti-weathering property, a resin film having anti-weathering property, such as a fluorine resin and an olefinic resin, is bonded on one surface or both surfaces of the gas barrier layer (a base material film) with an aid of, for example, an adhesive. The resin films are inevitably deteriorated by ultraviolet rays because the C-C bond of the main chain of the resins is easily broken. As a result, together with the deterioration of the anti-weathering resin films due to ultraviolet rays, the deterioration of the gas barrier property proceeds. With the proceeding of the deterioration of the gas barrier property, permeation of water vapor from outside to inside of the rear surface protection sheet occurs. The water vapor then hydrolyzes the adhesive of the adhesive layer bonding the base material film of the protection sheets, and causes deterioration of the adhesives. As a result, a problem arises in that the base material film and the anti-weathering resin film will peel off.

As described above, in order to improve anti-weathering property, conventional rear surface protection sheets include a resin film with anti-weathering property layered on a base material film of the protection sheets. However, there is a problem that peel off may easily occur with time at the interface of a layered body. In addition to the peel off problem occurring at layered rear surface protection sheet, it is also found that, at an interface between a sealant layer that is formed between the transparent base material at light receiving side and rear surface protection sheet to seal a solar cell element, and a rear surface protection sheet, peel off may easily occur. Such problems are described herein below.

In conventional solar cell modules, sheets formed of an EVA resin composition are used as the sealant sheets for sealing a solar cell element as described above. However, the EVA resin sheet basically tends to cause deterioration and change of properties, such as yellowing, cracks, and bubbles, if it is used for a long period of time. The occurrence of the deterioration and change of properties of the sealant sheet trigger corrosion of the solar cell element. When the corrosion of the solar cell element begins, the power generation capacity of the solar cell module decreases drastically. Once environmental conditions for using the solar cell module change into more severe state, the occurrence of such phenomena of the deterioration and the change of properties tends to increase. Such insufficient resistance to the use environment also causes limitation in applications of the conventional solar cells.

It is presumed that the deterioration and change of properties of the EVA resin sheet with the lapse of time would be caused by problems related to the ingredients of the EVA resin composition which is the material of the EVA resin sheet, as well as problems related to the molecular structure of the resin component. That is, it is presumed that an ester structure having a high hydrolysis property, a cross-linking agent for thermal cross-linking such as an organic peroxide or a multifunctional vinyl compound, a residual cross-linking agent, a reaction product, and a higher carbon number compound and a reaction terminal of an EVA cross-linking point would become an active spot, and the active spot gradually causes the deterioration and change of properties of the resin sheet.

As a measure to solve such problems, use of an adhesive sheet made of an ethylene-based resin that has the same excellent sealing properties as the EVA resin and hardly causes the deterioration and change of properties of the resin sheet is suggested (for example, Patent Literature 4) as a sealant. The sealant sheet is interposed between the rear surface protection sheet (back sheet) and a transparent resin sheet or a glass plate serving as the transparent plate at light receiving side so as to sandwich the solar cell element. The layered body obtained by interposing the sealant sheet is subjected to vacuum and pressure molding with application of heat (hereinafter, the process may be referred to as heat vacuum and pressure molding) so as to seal the solar cell element.

As described above, conventional rear surface protection sheets have a constitution that a fluorine-based resin with anti-weathering property or PET (polyethylene terephthalate) with anti-weathering property is adhered onto one surface or two surfaces of a base by using adhesives or the like, in order to have an anti-weathering property. Thus, when a sealant made of a polyethylene resin is used as a sealant, the polyethylene resin layer is in close contact with the fluorine-based resin or PET resin having an anti-weathering property, which is the outermost layer of a rear surface protection sheet. Compared to an EVA resin, the polyethylene resin is less polar, and thus the sealant layer made of polyethylene resin has lower adhesiveness to the fluorine-based resin or PET resin having an anti-weathering property in the sealant layer than the adhesiveness of a sealant layer made of EVA resin to the fluorine-based resin or PET resin having an anti-weathering property in the sealant layer. According to the studies by the inventors of the present invention, it was found that the adhesiveness of a sealant layer made of polyethylene resin to the fluorine-based, resin or PET resin having an anti-weathering property is insufficient for maintaining the sealing property of a solar cell module at practically useful level, and it may yield peel off with the lapse of time.

The peel off problem between the sealant made of an ethylene-based resin and a rear surface protection sheet also occurs in a case in which a transparent resin sheet is used as a transparent base material at light receiving side.

### Citation List

### Patent Literature

Patent Literature 1: Japanese utility model application publication No. 2-44995
Patent Literature 2: Japanese Patent Application Laid-open No. 2002-134771
Patent Literature 3: Japanese Patent Application Laid-open No. 2006-253264
Patent Literature 4: Japanese Patent Application Laid-open No. 2002-235048

### Summary

### Technical Problem

The present invention is achieved in view of the problems of the conventional techniques described above, and an object of the invention is to provide a base material for a solar cell module that has an excellent anti-weathering property, an excellent water resistant property, an excellent water vapor barrier property, flexibility that prevents deterioration of a water vapor gas barrier property even when the base is bent in a certain degree in an in-mold assembly molding process such as hot press molding and vacuum and pressure molding during manufacturing of a solar cell module, and adhesiveness to a sealant that is not suppressed even when a polyethylene sealant is used as a sealant, and a method for producing the base material for a solar cell module.

### Solution to Problem

In order to solve the aforementioned problems, the invention provides a base material for a solar cell module having the following constitution, and a method for producing the base material for a solar cell module.

[1] A base material for a solar cell module comprising:
   a base material film including at least one layer; and
   a coating layer including at least one layer formed on one surface or both surfaces of the base material film,
   wherein the coating layer is a copolymer layer obtained by curing a liquid coating film comprising an acrylic-based resin component A which comprises metal alkoxide having a reactive functional group (Y), an acrylic-based monomer having a reactive functional group (X) that reacts with the reactive functional group (Y), and an acrylic-based monomer without the reactive functional group (X); and an ethylene-based resin component B comprising a carboxyl group binding to the reactive functional group (Y) of metal alkoxide and including an ethylene monomer b1, a vinyl acetate monomer b2, and a monomer b3 of carboxylic acid vinyl esters other than vinyl acetate.
[2] The base material for the solar cell module according to the above [1], wherein the metal alkoxide is a compound represented by the general formula YM(OR)₃, YRM(OR)₂, or YR₂M(OR) (in the formulae, M represents a metal, R represents an alkyl group, and Y represents an ureido group or an isocyanate group).
[3] The base material for the solar cell module according to the above [1] or [2], wherein the addition amount of the ethylene-based resin component B is 1 to 99 parts by weight per 100 parts by weight of the acrylic-based resin component A.
[4] The base material for the solar cell module according to any one of the above [1] to [3], wherein the base material film is a layered film obtained by layering two or more films with an aid of silane based adhesives.
[5] The base material for the solar cell module according to any one of the above [1] to [3], wherein the base material film comprises a single layer and the single layer is a film attached with inorganic oxide vapor deposited film.
[6] The base material for the solar cell module according to any one of the above [1] to [4], wherein the base material film comprises at least two layers and at least one layer of them is a film attached with inorganic oxide vapor deposited film.
[7] The base material for the solar cell module according to any one of the above [1] to [6], wherein the material of the base material film is one or more kinds selected from a polyester resin, a polyolefin resin, a polystyrene resin, a polyamide resin, a polycarbonate resin, and a polyacrylonitrile resin.
[8] The base material for the solar cell module according to any one of the above [1] to [7], wherein an ultraviolet scattering agent or/and an ultraviolet absorbing agent is admixed in a single layer when the coating layer has a constitution of a single layer or in at least one layer when the coating layer has a multilayer constitution.
[9] A method for producing a base material for a solar cell module comprising:
   preparing a base material film including at least one layer,
   preparing a liquid containing acrylic-based resin component A which includes metal alkoxide having a reactive functional group (Y), an acrylic-based monomer having a reactive functional group (X) that reacts with the reactive functional group (Y), and an acrylic-based monomer without the reactive functional group (X); and ethylene-based resin component B which has a carboxyl group binding to the reactive functional group (Y) of metal alkoxide and includes an ethylene monomer b1, a vinyl acetate monomer b2, and a monomer b3 of carboxylic acid vinyl esters other than vinyl acetate,
   forming at least one coating film by coating the liquid on one surface or two surfaces of the base material film, and
   forming a coating layer comprising at least one copolymer layer by curing at least one coating film described above.
[10] The method for producing the base material for the solar cell module according to the above [9], wherein the metal alkoxide is a compound represented by the general formula YM(OR)₃, YRM(OR)₂, or YR₂M(OR) (in the formulae, M represents a metal, R represents an alkyl group, and Y represents an ureido group or an isocyanate group).
[11] The method for producing the base material for the solar cell module according to the above [9] or [10], wherein the addition amount of the ethylene-based resin component B is 1 to 99 parts by weight per 100 parts by weight of the acrylic-based resin component A.
[12] The method for producing the base material for the solar cell module according to any one of the above [9] to [11], wherein an ultraviolet scattering agent or/and an ultraviolet absorbing agent is admixed, during the preparing of a liquid, in a liquid for constituting a single layer when the copolymer layer has a constitution of a single layer or in a liquid for constituting at least one layer when the copolymer layer has a multilayer constitution.

### Advantageous Effects of Invention

The base material for a solar cell module according to the invention is a base material for a solar cell module with good practical utility, which has an anti-weathering property, a water resistance, a water vapor barrier property, and flexibility, and also adhesiveness to a sealant that is not suppressed even when a polyethylene sealant is used as a sealant. Further, according to the method for producing a base material for a solar cell module of the invention, a base material for a solar cell module with good practical utility, which has an anti-weathering property, a water resistance, a water vapor barrier property, and flexibility, and also adhesiveness to a sealant that is not suppressed even when a polyethylene sealant is used as a sealant can be provided.

### Brief Description of Drawings

FIG. 1 is a cross-sectional view illustrating an example of a base material for a solar cell module according to the present invention.
FIG. 2 is a schematic view to describe characteristics of a copolymer constituting a coating layer of a base material for the solar cell module according to the present invention.
FIG. 3 is a schematic view to describe characteristics of a polymer constituting a complex coating layer of a base material for a conventional solar cell module.
FIG. 4 is a schematic view to describe a self-repairing characteristic of a copolymer included in the coating layer of a base material for the solar cell module according to the present invention.
FIG. 5 is a drawing illustrating the infrared total reflection absorption spectrum of a dry coating film formed of a commercially available emulsion, which is used as acrylic-based resin component A in the liquid resin component of the Embodiments of the invention.
FIG. 6 is a drawing illustrating the infrared total reflection absorption spectrum of the copolymer layer that is produced in the Embodiment 1.

### Description of Embodiments

The base material for a solar cell module according to the present invention is a base material for a solar cell module which contains a base material film including at least one layer and a coating layer including at least one layer and formed on one surface or both surfaces of the base material film, in which the base material is characterized in that the coating layer is a copolymer layer obtained by curing a liquid coating film containing acrylic-based resin component A which includes metal alkoxide having a reactive functional group (Y), an acrylic-based monomer having a reactive functional group (X) that reacts with the reactive functional group (Y), and an acrylic-based monomer without the reactive functional group (X), and ethylene-based resin component B which has a carboxyl group binding to the reactive functional group (Y) of metal alkoxide and includes an ethylene monomer b1, a vinyl acetate monomer b2, and a monomer b3 of carboxylic acid vinyl esters other than vinyl acetate.

Further, the method for producing a base material for a solar cell module according to the present invention includes preparing a base material film including at least one layer, preparing a liquid containing acrylic-based resin component A which includes metal alkoxide having a reactive functional group (Y), an acrylic-based monomer having a reactive functional group (X) that reacts with the reactive functional group (Y), and an acrylic-based monomer without the reactive functional group (X), and ethylene-based resin component B which has a carboxyl group binding to the reactive functional group (Y) of metal alkoxide and includes an ethylene monomer b1, a vinyl acetate monomer b2, and a monomer b3 of carboxylic acid vinyl esters other than vinyl acetate, forming at least one coating film by coating the liquid on one surface or both surfaces of the base material film, and forming a coating layer consisting of at least one copolymer film by curing at least one coating layer described above.

As used herein, the expression "a liquid containing acrylic-based resin component A which includes metal alkoxide having a reactive functional group (Y), an acrylic-based monomer having a reactive functional group (X) that reacts with the reactive functional group (Y), and an acrylic-based monomer without the reactive functional group (X), and ethylene-based resin component B which has a carboxyl group binding to the reactive functional group (Y) of metal alkoxide and includes an ethylene monomer b1, a vinyl acetate monomer b2, and a monomer b3 of carboxylic acid vinyl esters other than vinyl acetate" means a water-based emulsion containing the resin component consisting of the acrylic-based resin component A and the ethylene-based resin component B with a predetermined concentration (preferably, final concentration of 50% by weight), and a resin solution obtained by dissolving in a non-water-based solvent the resin component consisting of the acrylic-based resin component A and the ethylene-based resin component B.

The base material film may be of a single layer structure, and may also be of a multilayered structure composed of two or more layers. The coating layer is formed on one surface or both surfaces of the base material film composed of the single layer or the multilayered structure of two or more layers. The coating layer formed on one surface or both surfaces of the base material film is the copolymer layer that is formed by polymerizing and curing the coating film of the liquid. The coating film may be formed as a single layer or as multiple layers.

When the base material film is formed as the multilayered structure, it is preferable that a silane adhesive layer is interposed in each interface of the base material film layers.
At least one layer of the base material film composed of at least one layer is preferably a film layer having an inorganic oxide vapor deposited film. That is, when the base material film is composed of a single layer, it is preferable that the film layer is the film layer having the inorganic oxide vapor deposited film. When the base material film is formed as the multilayered structure, it is preferable that at least one layer of the film layers is the layer having the inorganic oxide vapor deposited film. In this case, the film layers are bonded with each other with the silane adhesive interposed in each interlayer.

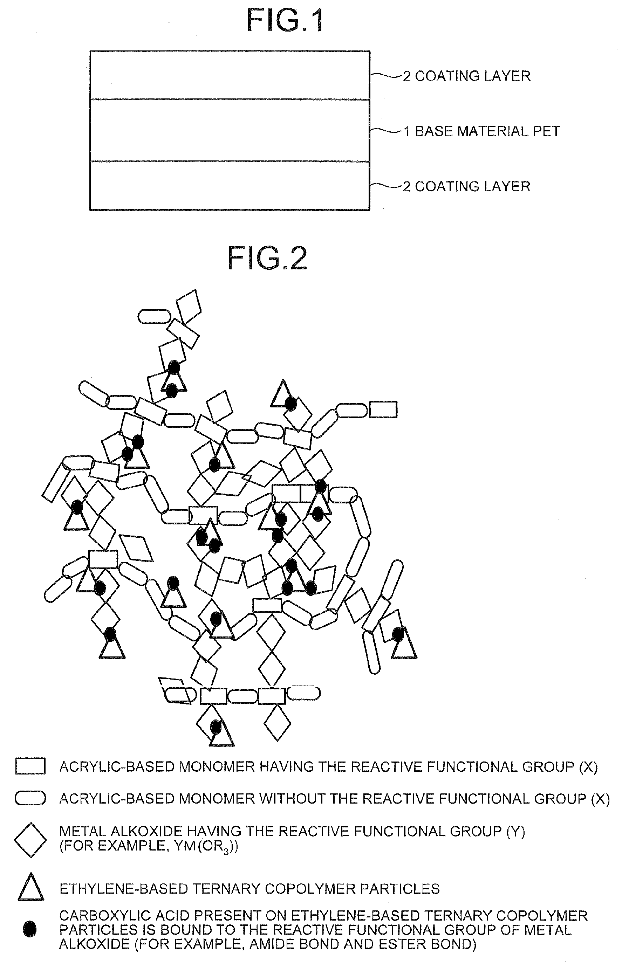

FIG. 1 is a cross-sectional view illustrating an example of a base material for a solar cell module according to the present invention. FIG. 1 illustrates a multilayered structure in which a base material film 1 is composed of a single layer, and a coating layer of a single layer (2) is formed on both surfaces of the base material film 1. Each element of the structure will be described herein below with reference to the figure.

### (Preparing of Base Material Film)

The film for use as the base material film 1 may be a resin film that is capable of being molded for a predetermined heating period of time that is appropriately adjusted within a range so as not to be melted or softened, because the film is heated in the hot pressing for forming a solar cell module. Examples of the material of the base material film may include one or more kinds of resin selected from a polyester resin, a polyolefin resin, a polystyrene resin, a polyamide resin, a polycarbonate resin, and a polyacrylonitrile resin. Specifically, an engineering plastic film may be used as the base material film 1, and examples of which may include a polyester film including a polyethylene terephthalate (PET) film and a polyethylene naphthalate (PEN) film, a polyolefin film including a polyethylene film and a polypropylene film, a polystyrene film, a polyamide film, a polycarbonate film, a polyacrylonitrile film, and a polyimide film.
The thickness of the base material film 1 is in a range from 3 to 300 µm.

The surface of the film is preferably processed to be oxidized by, for example, irradiation with oxygen plasma or corona discharge, and flame treatment. The oxidization processing of the surface results in a large number of functional groups being present on the surface. The film having a large number of functional groups on the surface thereof tends to have good adhesiveness with the silane adhesive. Accordingly, the film whose surface is appropriately processed is preferably used as the base material film 1.

The base material film 1 is an example composed of a single layer. The film used as the single layer base material film 1 may be a film having inorganic oxide vapor deposited on the surface thereof. In the present invention, when the base material film is formed as the multilayered structure, one or more layers of the multilayered structure may be a film layer having the inorganic oxide vapor deposited film. The number of inorganic oxide vapor deposited film layers built in the base material film may be changed depending on a required gas barrier property. When the films each having the vapor deposited film are bonded with each other, it is preferable that the surface having the vapor deposited film of one film is bonded to a surface having no vapors deposited film of the other film.

Examples of inorganic oxide for vapor deposition may include silicon oxide, aluminum oxide, and zinc oxide. The thickness of the vapor deposited film is preferably from 1 nm to 100 nm.

As an adhesive used to bond the films witch each other, a variety of adhesives, such as urethane, acrylic-based, epoxy, and silicone adhesives, have been used conventionally. However, those adhesives have a problem of deterioration in adhesion performance caused by hydrolysis under high temperature and high humidity. In contrast, in the present invention, the silane adhesive is used for bonding the films to constitute the base material film 1 in the multilayered structure. The silane adhesive has excellent adhesive performance even under high temperature and high humidity conditions.

Examples of the silane adhesive referred to herein may include a conventionally used silane coupling agent and a mixture containing alkoxysilane, which is a sort of the metal alkoxide compounds included in the acrylic-based resin component A (a ternary monomers) used for forming the coating layer in the present invention.

In the silane adhesive, an alkoxy group of alkoxysilane is hydrolyzed to produce a silanol group (Si-OH). The silanol group reacts and bonds with a carboxyl group and a hydroxyl group that are present on the surface of the film and oxidized by oxygen plasma or corona discharge. Accordingly, the silane adhesive brings about good adhesion between the films. In addition, the silane adhesive is not hydrolyzed even under high temperature and high humidity conditions, and thereby keeps good adhesion property. Furthermore, a silanol bond has a high resistance against UV energy, and accordingly the silane adhesive has an excellent anti-weathering property.

When the base material film 1 is composed of two or more film layers bonded with each other with the silane adhesive, the combination of the films may be any of a combination of the films of the same kind, a combination of the films of different kinds, a combination of the films of the same kind in which one of which has inorganic oxide vapor deposited thereon, and a combination of the films of different kinds in which one of which has inorganic oxide vapor deposited thereon.

### (Preparing of Liquid)

The coating layer 2 is formed on one surface or both surfaces (in FIG. 1, on both surfaces) of the base material film 1 with a thickness in a range from 5 to 300 µm. The coating layer 2 is a copolymer layer obtained by curing a liquid coating film containing resin components consisting of the acrylic-based resin component A which includes metal alkoxide having a reactive functional group (Y), an acrylic-based monomer having a reactive functional group (X) that reacts with the reactive functional group (Y), and an acrylic-based monomer without the reactive functional group (X), and the ethylene-based resin component B which has a carboxyl group binding to the reactive functional group (Y) of metal alkoxide and includes an ethylene monomer b1, a vinyl acetate monomer b2, and a monomer b3 of carboxylic acid vinyl esters other than vinyl acetate. As described herein, the term "liquid" means a water-based emulsion containing the resin component consisting of the acrylic-based resin component A and the ethylene-based resin component B with a predetermined concentration (preferably final concentration of 50% by weight), or a resin solution obtained by dissolving in a non-water-based solvent the resin component consisting of the three monomers described above.

### (Acrylic-based Resin Component A)

As described in the above, the acrylic-based resin component A that is used in the invention is a resin component consisting of metal alkoxide having a reactive functional group (Y), an acrylic-based monomer having a reactive functional group (X) that reacts with the reactive functional group (Y), and an acrylic-based monomer without the reactive functional group (X).

The metal alkoxide having the reactive functional group (Y) is a compound represented by any of the general formulae YM(OR)₃, YRM(OR)₂, and YR₂M(OR) (in the formulae, M represents a metal, R represents an alkyl group, and Y represents an ureido group or an isocyanate group).

Examples of the metal alkoxide having the reactive functional group (Y) include α,β-ethylenically unsaturated monomers containing silane in particular, for example, one kind selected from or a mixture of α,β-ethylenically unsaturated monomers such as:
vinyltriisopropoxysilane, allyltrimethoxysilane, diallyldimethylsilane, 3-methacryloxypropyltrimethoxysilane, 3-methacryloxypropylmethyldimethoxysilane, 3-methaoryloxypropyltri-ethoxysilane, 3-mercaptopropyl triethoxysilane, 3-octanoylthio-1-propyl triethoxysilane 3-aminopropyl triethoxysilane, 3-aminopropyltrimethoxysilane, N-(2-aminoethyl)-3-aminopropylmethyldimethoxysilane, N-(2-aminoethyl)-3-aminopropyltrimethoxysilane, 3-ureidopropyl triethoxysilane, 3-isocyanatepropyl triethoxysilane, and 3-isocyanatepropyltrimethoxysilane.

In addition to the metal alkoxide having the reactive functional group (Y), tetraalkoxysilane, trialkoxy aluminum, and tetraalkoxy titanium may be added.

When the metal alkoxide has an isocyanate group as the reactive functional group (Y), a capping agent (also called a blocking agent or a protecting agent) for the reactive functional group (Y) is used so as to suppress the direct reaction with water and effectively promote the reaction with the reactive functional group (X). As the capping agent, any suitable aliphatic, alicyclic, or aromatic alkyl mono-alcohol, or phenolic compounds may be used.

Examples of the aliphatic, alicyclic, or aromatic alkyl mono-alcohol may include: lower aliphatic alcohol, such as methanol, ethanol, n-butanol, 2-methyl-2-propanol, or 2-methyl-1-propanol; alicyclic alcohol such as cyclohexanol; or aromatic alkyl alcohol, such as phenyl carbinol, or methyl phenyl carbinol.

Examples of the phenolic compounds may include phenol itself, and substituted phenol such as cresol or nitrophenol (the substituent group thereof does not affect coating operation).

As the capping agent, glycol ether may also be used in addition to the aforementioned substances. Examples of suitable glycol ether may include ethylene glycol butyl ether, diethylene glycol butyl ether, ethylene glycol methyl ether, and propylene glycol methyl ether. Diethylene glycol butyl ether is preferable among those glycol ethers.

Other examples of the capping agent may include: oximes such as methylethylketooxime, acetone oxime, or cyclohexanone oxime; lactams such as ε-caprolactam; and amines such as dibutylamine.

A suitable capping may be selected and used so as to be appropriate for drying and reaction temperature of the coating film.

The polymerization reaction of the acrylic-based resin component A proceeds as follows. The capping agent modified on the isocyanate group in the emulsion is volatilized (azeotropy) with water by being heated and dried after being applied, or decomposed by being heated, so that the capping agent is separated from the reactive functional group (isocyanate group). This triggers polymerization. The detachment reaction of the capping agent occurs upon heating at equal to or higher than 80°C. When the heating temperature exceeds 120°C, polymerization of the monomers rapidly proceeds. Accordingly, heating aiming at removal of the capping agent is preferably performed in a temperature range from 80°C to 120°C. The detachment reaction of the capping agent simultaneously proceeds in a usual drying of the coating film.

The reactive functional group (X) is a functional group that reacts and bonds with the reactive functional group (Y) of the metal alkoxide, such as an ester group, an epoxy group, a ketone group, an amino group, a hydroxyl group, an ureido group, or an isocyanate group.

Examples of the acrylic-based monomer having the reactive functional group (X) may include an α,β-ethylenically unsaturated monomer, for example, an a,β-ethylenically unsaturated monomer containing a hydroxyl group, such as: hydroxyethyl (meth)acrylate, 2-hydroxyethyl (meth)acrylate, hydroxypropyl (math)acrylate, hydroxybutyl (meth)acrylate, methacryl alcohol, 4-hydroxybutyl acrylate glycidyl(epoxy) ether, and an adduct of hydroxyethyl (meth)acrylate and ε-caprolactone.

Further, the expression "without the reactive functional group (X)" means that a functional groups that is reactive with then metal alkoxide having the reactive functional group (Y) is not contained.
Examples of the acrylic-based monomer without the reactive functional group (X) may include α,β-ethylenically unsaturated monomers, such as (meth)acrylate ester [for example, methyl (meth)acrylate, ethyl (meth)acrylate, n-propyl (meth)acrylate, isopropyl (meth)acrylate, n-butyl (meth)acrylate, isobutyl (meth)acrylate, t-butyl (meth)acrylate, 2-ethylhexyl (meth)acrylate, lauryl methacrylate, phenyl acrylate, isobornyl (meth)acrylate, cyclohexyl methacrylate, t-butylcyclohexyl (meth)acrylate, dicyclopentadienyl (meth)acrylate, or dihydrodicyclopentadienyl (meth)acrylate].

### (Ethylene-based Resin Component B)

The expression "ethylene-based resin component B having a carboxyl group binding to the reactive functional group (Y) of metal alkoxide" is a resin component consisting of an ethylene monomer b1; a vinyl acetate monomer b2; and a monomer b3 of carboxylic acid vinyl esters other than vinyl acetate.

The monomer b1 is ethylene. Further, the monomer b2 is vinyl acetate.

The monomer b3 is carboxylic acid vinyl esters other than vinyl acetate. Examples of the carboxylic acid vinyl esters include vinyl propionate, vinyl butyrate, vinyl valerate, vinyl capronate, vinyl heptanoate, vinyl caprylate, vinyl capriate, vinyl myristate, vinyl palmitate, vinyl stearate, vinyl cyclohexane carboxylate, vinyl pyvalate, vinyl octylate, vinyl monochloroacetate, vinyl adipate, vinyl crotonate, vinyl sorbate, vinyl benzoate, vinyl cinnamate, vinyl pelargonate, vinyl versatate, vinyl n-undecanoate, vinyl laurylate, and vinyl laurate. Further, as the monomer b3, carboxylic acid vinyl esters copolymerized with other monomer can be also used.
Examples of other monomer include acrylic-based acid esters (for example, methyl acrylate, ethyl acrylate, and 2-ethyl hexyl acrylate), acrylamide, acrylamide derivatives (for example, alkoxymethyl acrylamide and N-methylol acrylamide), and methacrylic-based acid esters (for example, methyl methacrylate, ethyl methacrylate, butyl methacrylate, and 2-ethylhexyl methacrylate). The third monomer b3 is preferably 10 parts by weight or less per 100 parts by weight of ethylene (monomer b1).

The polymerization of the aforementioned ethylene-based resin component B is initiated in an emulsion by adding a radical polymerization initiator. The temperature condition for the polymerization reaction may be the same as the preferred range of the aforementioned polymerization of the acrylic-based resin A. Specifically, the temperature range for having polymerization of the ethylene-based resin component B is preferably selected within the range of 80°C to 120°C.

### (Mixing Ratio between Acrylic-based Resin Component A and Ethylene-based Resin Component B)

According to the invention, the resin component in the liquid consists of the acrylic-based resin component A and the ethylene-based resin component B. Addition amount of the ethylene-based resin component B per 100 parts by weight of the acrylic-based resin component A is equal to or greater than 1 part by weight but less than 99 parts by weight, and preferably equal to or greater than 5 parts by weight but less than 80 parts by weight.

Mixing of the acrylic-based resin component A and the ethylene-based resin component B can be achieved by simultaneously dispersing them in the same dispersion. However, it is preferable that an emulsion of the acrylic-based resin component A and an emulsion of the ethylene-based resin component B are separately prepared and two types of the emulsion after preparation are mixed with each other.

For the latter case in which two emulsions are separated prepared followed by mixing them, the emulsion A and the emulsion B for the acrylic-based resin component A and the ethylene-based resin component B, respectively, are prepared such that concentration of the resin component A and the resin component B is 40 to 60% by weight. Next, by adding 1 to 99 parts by weight of the emulsion B to 100 parts by weight of the emulsion A followed by mixing, a liquid can be obtained.

With regard to the liquid coating film prepared with the mixing ratio described above, when the resin components in the coating film are polymerized under predetermined polymerization condition, a copolymer layer with a micro structure of an island-in-sea structure is obtained in which the acrylic-based copolymer constitutes a sea phase and the ethylene-based copolymer constitutes an island phase. According to the island-in-sea structure, the ethylene-based copolymer in particle phase is scattered in the acrylic-based copolymer which constitutes a sea phase (that is, matrix), and the acrylic-based copolymer and the ethylene-based copolymer are linked to each other via binding of the carboxy group present on the ethylene-based copolymer particle to the reactive functional group (Y) of metal alkoxide present in the acrylic-based copolymer.

When addition amount of the ethylene-based resin component B is less than 1 part by weight compared to 100 parts by weight of the acrylic-based resin component A, the ethylene-based copolymer may be insufficiently formed. On the other hand, when addition amount of the ethylene-based resin component B is equal to or more than 99 parts by weight compared to 100 parts by weight of the acrylic-based resin component A, the aforementioned island-in-sea structure may not be obtained.

The copolymer obtained by copolymerization of resin components consisting of an acrylic-based resin component and an ethylene-based resin component is obtained by, as a last step, coating the liquid as a copolymer layer on a base material film. The timing for mixing, coating, and polymerization of each monomer may be achieved by combinations like mixing → polymerization (semi-polymerization) → coating (after additional mixing, if remaining monomers are present) → polymerization (drying), or mixing → coating → polymerization (drying).

### (Method of preparing emulsion using water-based solvent)

The water-based solvent for preparing an emulsion of resin components may be, for example, ion-exchange water. If needed, a conventionally used dispersing agent may be added to an aqueous vehicle containing an organic solvent such as alcohol so as to enhance dispersing property. Thereafter, a conventionally used homogenizer (for example, "NR-300", a name of a product manufactured by Microtec Co., Ltd.) may be used to process the water-based solvent so as to uniformly disperse the water-based solvent. Then, the aforementioned combination of the three kinds of monomers or two kinds of preliminary mixed monomers, and a polymerization initiator may be added dropwise into the water-based solvent while the water-based solvent is heated and stirred, to perform polymerization. The concentration of the resin component is preferably from 30 to 60% by weight.

The aforementioned method can reduce deviation of the particle size of the resin component constituting the emulsion from the desired particle size. As a result, resin component particles within a preferable particle size range can be obtained.

Examples of the polymerization initiator may include: azo oil compounds (for example, azobisisobutyronitrile, 2,2'-azobis(2-methylbutyronitrile), 2,2'-azobis(2-(2-imidazolin-2-yl)propane, and 2,2'-azobis(2,4-dimethylvaleronitrile); aqueous compounds (for example, anionic compounds, such as 4,4'-azobis(4-cyanovaleric acid), 2,2-azobis(N-(2-carboxyethyl)-2-methylpropionamidine), and cationic compounds, such as 2,2'-azobis(2-methylpropionamidine); redox oil peroxides (e, g., benzoyl peroxide, para-chlorobenzoyl peroxide, lauroyl peroxide, and t-butyl perbenzoate); and aqueous peroxides (for example, potassium persulfate, and ammonium persulfate).

In addition to the aforementioned dispersing agent, dispersing agents that are usually used by a person skilled in the art, and an emulsifying agent may be used together. Examples thereof may include ANTOX MS-60 (a name of a product manufactured by Nippon Nyukazai Co., Ltd.), Eleminol JS-2 (a name of a product manufactured by Sanyo Chemical Industries, Ltd.), Adekalia Soap NE-20 (a name of a product manufacture by Asahi Denka Co., Ltd.), and AQUARON HS-10 (a name of a product manufactured by Daiichi Kogyo Seiyaku Co., Ltd.).

The mixing ratio of the conventionally used dispersing agent relative to the resin component may be adjusted to a conventionally adopted ratio for preparing the emulsion. For example, the mixing ratio may be adjusted such that the solid content weight ratio is in a range from 5/95 to 20/80. When the ratio is lower than 5/95, dispersed particles tend to be cohered to form aggregates which deteriorate smoothness of the coating film. On the other hand, when the ratio exceeds 20/80, control of the film thickness tends to be difficult.

If necessary, it is allowable to use a chain transfer agent such as mercaptan like laurylmercaptan, as well as α-methylstyrene dimer for adjusting molecular weight.

The polymerization reaction temperature of the mixed monomers is determined in accordance with the polymerization initiator, For example, when an azo-based initiator is used, preferable temperature is 60 to 90°C. When a redox-based initiator is used, preferable temperature is 30 to 70°C. The mixing amount of the initiator relative to the total amount of the emulsion is generally from 0.1 to 5% by mass, and preferably from 0.2 to 2% by mass.

As described above, the preferred process to be employed for polymerization of acrylic-based monomer is the process in which the two kinds of monomers that are "the acrylic-based monomer having the reactive functional group (X)" and "the acrylic-based monomer without the reactive functional group (X)" are mixed or partially polymerized to be in a semi-polymerization state, and thereafter the mixture is further mixed with the remaining "metal alkoxide having the reactive functional group (Y)" and polymerized.

When the two kinds of monomers are preliminarily reacted, the polymerization takes from 1 to 8 hours.

The average particle size of the two-component semi-polymerized resin particle obtained by partially polymerizing (semi-polymerization) the aforementioned two kinds of monomers that are "the acrylic-based monomers having the reactive functional group (X)" and "the acrylic-based monomer without the reactive functional group (X)" is preferably in a range from 0.05 to 0.30 µm. When the particle size is smaller 0.05 µm, workability improvement effect may become small. On the other hand, when the particle size is larger than 0.30 µm, an outer appearance of the resulting coating film may be deteriorated. The particle size may be controlled by, for example, adjusting the composition of the mixture of the two kinds of monomers, and emulsion polymerization conditions.

A weight average molecular weight of the two-component semi-polymerized resin particles is preferably from 6000 to 12000. When the weight average molecular weight is lower than 6000, control of the film thickness tends to be difficult. On the other hand, when the weight average molecular weight is more than 12000, smoothness of the coating film tends to lower.

The resin solid content in the emulsion having the aforementioned composition is preferably from 3 to 20% by mass. When the resin solid content amount is lower than 3% by mass, control of the film thickness tends to be difficult. On the other hand, when the resin solid content amount is more than 20% by mass, smoothness of the coating film tends to lower.

Mixing of an emulsion containing the acrylic-based resin component A and an emulsion containing the ethylene-based resin component B is carried out by, for example, a process including semi-polymerization based on partial polymerization of the aforementioned two monomers in an emulsion containing the acrylic-based resin component A, mixing the remaining monomers to have an emulsion of acrylic-based resin component, and adding an emulsion of the ethylene-based resin component to the emulsion of the acrylic-based resin.

With regard to the emulsion of the ethylene-based resin component, it is preferable that, instead of polymerizing three kinds of the monomers all together, two kinds of the monomers are semi-polymerized, and then added with remaining monomers to give an emulsion. By adopting a process including partial polymerization of each constitutional monomers before mixing the emulsion of the acrylic-based resin and the emulsion of the ethylene-based resin component followed by mixing two emulsions and copolymerization, and also by controlling suitably the degree of partial polymerization during the process, it becomes more easy to have the acrylic-based copolymer in sea phase and the ethylene-based copolymer in island phase.

### (Method of Preparing Resin Solution using Non-water-based Solvent)

As the non-water-based solvent, an organic solvent, such as toluene or ethyl acetate, is used. As the non-water-based solvent, other solvents such as xylene, N-methyl pyrrolidone, butyl acetate, aliphatic and/or aromatic compounds having a relatively high boiling point, butyl diglycol acetate, and acetone may also be appropriately used.

As the polymerization initiator, an initiator that generates radicals by application of heat (azo-based initiators and peroxide-based initiators) is used.

Each resin component described above and the polymerization initiator are dissolved in the non-water-based solvent, so that two kinds of resin solutions are prepared in which the monomers are polymerized or partially polymerized (semi-polymerization). Then, two kinds of the resin solutions are mixed to form liquid. The concentration of the resin component in the resin solution is preferably from 30 to 60% by weight, and more preferably 50% by weight.

If necessary, the liquid may further contain an ultraviolet scattering agent or/and an ultraviolet absorbing agent, in addition to the resin component and the solvent. Examples of the ultraviolet scattering agent may include fine powder of zinc oxide, or titanium oxide. Examples of the ultraviolet absorbing agent may include pigment having an ultraviolet absorbing property, and an acrylic-based polymer in which benzotriazole group is incorporated at a high concentration. The addition of a small amount of the ultraviolet scattering agent or/and the ultraviolet absorbing agent can further improve the anti-weathering property of the coating layer. When the coating layer has the multilayered structure, it is preferable that the ultraviolet scattering agent or/and the ultraviolet absorbing agent be added to one or more layers of the coating layers. It is further preferable that the ultraviolet scattering agent or/and the ultraviolet absorbing agent be added to two or more coating layers or all of the coating layers.

As an emulsion containing the acrylic-based resin component, there is a commercially available product. Therefore, it is possible to use such products. Examples of the commercially supplied products may include "Silas" (product name) product manufactured by Toagosei Co., Ltd., and "CIELUSTER MK" (product name) manufactured by Nippon Paint Co., Ltd.

### (Process for Forming Coating Film of Liquid)

The coating film of the liquid is formed on one surface or both surfaces of the base material film 1 (both surfaces in FIG. 1) such that the thickness of the film after being dried is from 6 to 350 µm. As the method for applying the liquid, known techniques that are generally used, such as a dipping method, a roll coating method, a screen printing method, and a spraying method, may be used. Further, in order to uniformly control the thickness, thin coating layers may be multi-layered to be a predetermined thickness. When the thin coating layers are multi-layered, a previously applied layer is dried, a subsequent layer is applied, dried, and then a still subsequent layer is applied, and such procedures are repeated.

### (Process for Forming Coating Layer consisting of Copolymer Layer of Acrylic-based Resin Component A and Ethylene-based Resin Component B)

This process includes drying the coating film, and after drying, curing the dried coating film to finally form a cured film (the copolymer coating layer) composed of the acrylic-based and ethylene-based copolymers.

### (Process for Drying Coating Film)

In the coating film drying process, the solvent in the coating film of the liquid is vaporized to stabilize the shape of the coating film. A drying temperature is preferably 80°C to 120°C. When the temperature is lower than 80°C, evaporation of the solvent becomes insufficient. On the other hand, when the temperature is higher than 100°C, this process initiates polymerization of the unreacted monomers in the coating film. A time period for drying depends on the drying temperature. For example, the drying time is preferably 10 minutes to 15 minutes at 100°C.

### (Process for Curing Dried Coating Film)

In this process, the coating film whose shape has been stabilized by drying is cured by polymerizing the monomers that have not been reacted in the coating film. The polymerization temperature of the unreacted monomers is preferably 80°C to 120°C. When the temperature is lower than 80°C, the polymerization becomes insufficient. On the other hand, when the temperature is higher than 120°C, PET starts shrinking if the layer is formed on PET, and the adhesiveness of the coating film is also adversely affected. A time period for polymerization depends on the polymerization temperature. For example, the polymerization time is preferably 10 minutes to 15 minutes at 100°C.

### (Characteristics of Copolymer Layer and Sheet having Copolymer Layer as Coating Layer)

As described above, the copolymer layer has a micro structure of an island-in-sea structure, in which the acrylic-based copolymer constitutes a sea phase (that is, matrix) while the ethylene-based copolymer constitutes an island phase. According to the island-in-sea structure, the ethylene-based copolymer, which is present in particle phase, is scattered in the acrylic-based copolymer which constitutes a sea phase, and the acrylic-based copolymer and the ethylene-based copolymer are linked to each other via binding of carboxylic acid present on the ethylene-based copolymer particle to the reactive functional group (Y) of metal alkoxide present in the acrylic-based copolymer.

The acrylic-based copolymer served as a matrix of the coating layer 2 has a gas barrier property and an anti-weathering property while maintaining flexibility. Therefore, a sheet obtained therefrom functions as a base material for solar cell module, and has excellent long-term reliability.

Conventionally, as disclosed in Patent Literature 3 or the like, polyvinyl alcohol (PVA) has been used as a polymer material having water solubility. PVA has a water vapor permeation rate of 1100 g/m²·24 hours (measurement conditions: 25°C, 90% RH, and thickness of 25 µm).
Although PVA has such a poor water vapor barrier property, it has good flexibility. In the conventional base material for a solar cell module, an inorganic oxide vapor deposited film served as a gas barrier layer alone cannot avoid cracks upon bending. Therefore, a film of a flexible polymer such as PVA is layered thereon to ensure the gas barrier property while maintaining flexibility against bending. Accordingly, the structure without the inorganic oxide vapor deposited film is insufficient in gas barrier property. That is, since the number of the layering increases, it is difficult to control the total thickness of the sheet.

In the present invention, as a copolymer material constituting the matrix of the coating layer for ensuring the gas barrier property, an acrylic-based monomer is used as a monomer copolymerizable with a metal alkoxide. It is generally known that polymethyl methacrylate (PMMA), which is an acrylic-based resin of the polymer, has a water vapor permeation rate of 41 g/m²·24 hours (measurement conditions: 25°C, 90% RH, and thickness of 25 µm), and thus has a better gas barrier property than that of PVA.

Further, the measurement values of the water vapor permeation rates of polyvinyl alcohol and polymethyl methacrylate are cited from Takeo Yasuda, "Methods of testing all the dynamic properties of plastic materials and evaluation results <5>", Plastics, Vol. 51, No. 6, page 119.

In the present invention, the monomer materials of the acrylic-based copolymer for constituting the matrix of the coating layer consist of three kinds of monomers that are the acrylic-based monomer having the reactive functional group (X), the acrylic-based monomer without the reactive functional group (X), and the metal alkoxide having the reactive functional group (Y) that is reacted with the reactive functional group (X). Further, a liquid containing, as a resin component, the resin component A composed of these three kinds of monomers and the ethylene-based resin component B is formed. The liquid is then processed to be the copolymer layer in a form of a film, which is utilized as the coating layer.

In the copolymer layer (coating layer) obtained by polymerizing and curing the coating film of the liquid consisting of the acrylic-based resin component A and the ethylene-based resin component B described above, as illustrated in FIG. 2, the acrylic-based copolymer resulting from polymerization of the resin component A is present as a matrix. In the acrylic-based copolymer, two kinds of acrylic-based monomers are bonded to form a chain by a radical polymerization reaction. The formed chain of the acrylic-based polymer maintains flexibility. In the chain of the acrylic-based polymer, the plural functional groups (X) derived from the acrylic-based monomer having the reactive functional group (X) are present with intervals. The functional group (X) reacts and bonds with the functional groups (Y) in the metal alkoxide. In addition, an M-O bond is formed by hydrolysis between the metal alkoxides having the reactive functional group (Y). As a result, the matrix copolymer acquires a mesh structure. The mesh structure can realize flexibility, high water vapor gas barrier property and high anti-weathering property. Consequently, the sheet of the present invention is free from a problem of having cracks by bending and consequent remarkable gas barrier property deterioration.

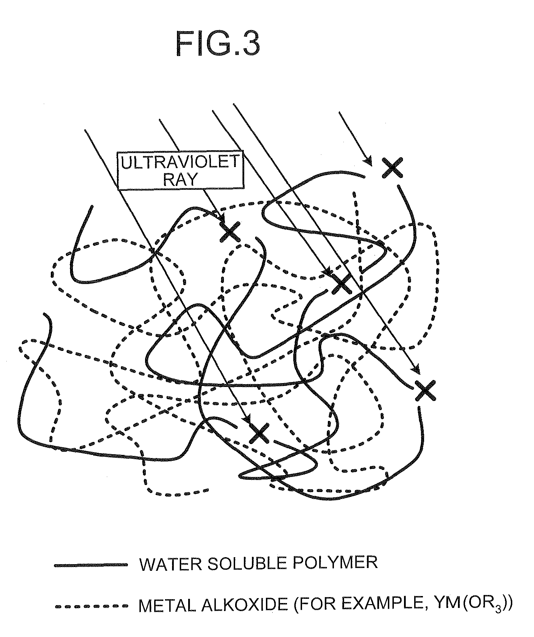

The conventional product uses a fluorine-based resin bonded on the gas barrier layer described above as a resin film having the anti-weathering property. As illustrated below (that is, Table 1), C-F bond energy is 116 kcal, and much stronger than the energy of ultraviolet rays of 96 kcal. However, C-C bond energy of the main chain is 85 kcal, which is weaker than the energy of ultraviolet rays. Therefore, ultraviolet rays cause deterioration of the resin. In addition, as illustrated in FIG. 3, the complex of the metal alkoxides of the gas barrier layer and polymer is mere a complex in which the polymer has no chemical bond with the hydrolysis products of the metal alkoxides. Therefore, if the C-C bond as the main chain of the polymer is broken by ultraviolet rays (part indicated by "X" in FIG. 3), the polymer is deteriorated by ultraviolet rays. As a result, a problem arises in that the water vapor gas barrier property markedly deteriorates.

**Table 1**

| Various energy | Energy (kcal/mol) |
|---|---|
| Ultraviolet rays | 96 |
| C-F bond | 116 |
| C-C bond | 85 |
| Si-O bond | 106 |
| Ti-O bond | 145 |
| Al-O bond | 115 |

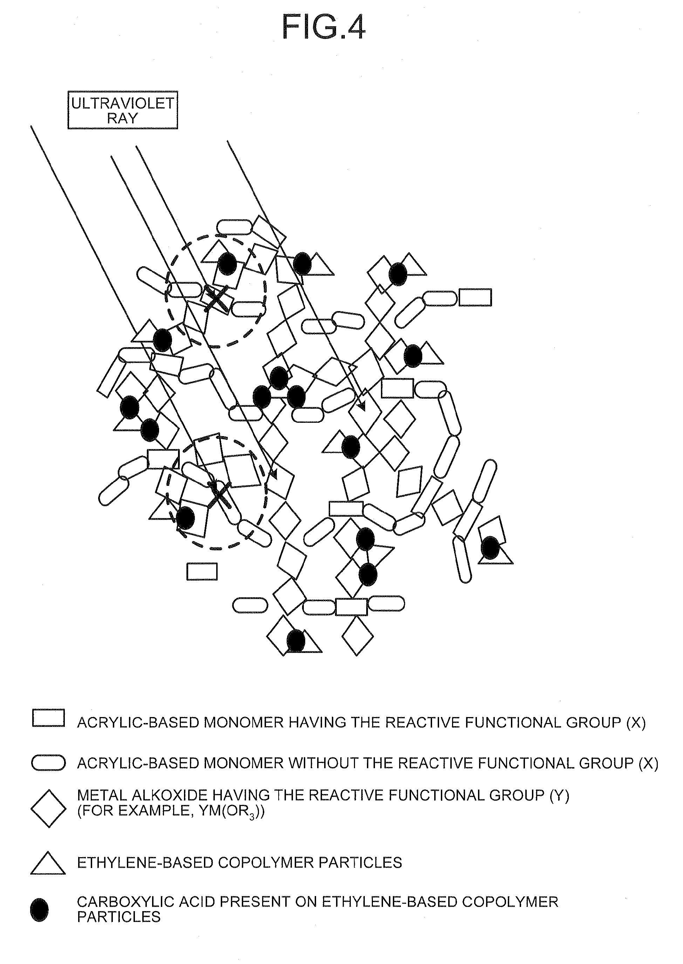

In contrast, in the acrylic-based copolymer layer for constituting the matrix of the coating layer of the base material for a solar cell module according to the present invention, as illustrated in FIG. 4, even if the C-C bond of the acrylic-based polymer part (85 kcal) is broken by ultraviolet rays (part indicated by "X" in FIG. 4), the M-O bond formed by the metal alkoxides (106 to 145 kcal) is not broken. In addition, even if the hydrolysis of the metal alkoxides proceeds due to humidity in the air or the polymer and the C-C bond of the acrylic-based polymer is broken by ultraviolet rays, increase in the number of M-O bonds can cause self-repairing. Therefore, as a whole, ultraviolet rays cause almost no deterioration.

Further, it is considered that the metal alkoxides are hydrolyzed by moisture, resulting in the M-O bonds being formed in a mesh structure. On the other hand, it is considered that a -CH₂-CHR- of an acrylic-based polymer is rarely hydrolyzed. Consequently, the sheet of the present invention does not have the defect of the conventional sheet having the structure in which a film having an anti-weathering property and a base material film having a gas barrier property are bonded with an adhesive. That is, the sheet of the present invention is free from a problem of deterioration of the adhesive by hydrolysis and subsequent peeling of the films as a result of deterioration of resin film during its use for a long period of time to allow incorporation of moisture from outside.

Meanwhile, in the coating layer, the ethylene-based copolymer present in particle phase is scattered on the matrix (that is, the acrylic-based copolymer) as illustrated in FIGS. 2 and 4. Further, the ethylene-based copolymer present in particle phase is linked to the matrix via binding of the carboxy group present on the ethylene-based copolymer particle to the reactive functional group (Y) of metal alkoxide present in the acrylic-based copolymer.

More specifically, when the metal alkoxide has an isocyanate group, the amine generated by reaction of isocyanate of the metal alkoxide with water is reacted with the carboxylic acid (carboxy group) present on surface of the ethylene-based copolymer particle to form an amide bond. Alternatively, when the metal alkoxide has an epoxy group, the epoxy group reacts with the carboxylic acid (carboxy group) present on surface of the ethylene-based copolymer particle to form an ester bond.

As described above, the ethylene-based copolymer is scattered as particle phase in the coating layer and bound to the matrix (acrylic-based copolymer) having excellent flexibility. Further, the ethylene-based copolymer consists of an ethylene monomer b1, a vinyl acetate monomer b2, and a monomer b3 of carboxylic acid vinyl esters other than vinyl acetate. In the ethylene-based copolymer, the carboxylic acid derived from the monomer b3 of carboxylic acid vinyl esters other than vinyl acetate is chemically bonded (that is, hydrogen bond) to a hydrophilic group like -OCH₂-, -COOCH₂, or the like derived from the molecular structure of PET used as a base material film, and also the ethylene chain derived from the ethylene-based monomer b1 is in sufficiently close contact with the ethylene chain of the ethylene-based material used as a sealant according to thermo compression during heating and vacuum molding, and as a result, they are chemically bonded to each other (that is, a bond which is based on molecular force when a contact close enough to allow a covalent bond occurs). Accordingly, the coating layer is adhered accompanying a chemical bond to a resin like PET via the particles of the ethylene-based copolymer, and therefore excellent adhesion is yielded and it is unnecessary to worry about peel off between the base material film and the copolymer layer (that is, coating layer). Further, for the same reasons, even for a case in which an ethylene-based material is used for a sealant, the coating layer forms strong adhesion both to the base material film and the sealant, and therefore it is unnecessary to worry about peel off between the base material film and the sealant.

As described above, the base material for a solar cell module according to the present invention can be provided as a base material for a solar cell module that has an anti-weathering property, a water resistant property, a water vapor barrier property, flexibility, and excellent practical usefulness that prevents deterioration of adhesiveness to a sealant that is not suppressed even when a polyethylene sealant is used as a sealant.

### Embodiments

In the following embodiments, in terms of the acrylic-based resin component A, 3-glycidoxypropyl triethoxysilane (commonly in Examples 1 to 3) or 3-isocyanatepropyl triethoxysilane (Example 4) was used as the metal alkoxide having the reactive functional group (Y) among the three kinds of monomers, that is, the metal alkoxide having the reactive functional group (Y), the acrylic-based monomer having the reactive functional group (X) that is reactive with the reactive functional group (Y), and the acrylic-based monomer without the reactive functional group (X). As the remaining monomers that are the acrylic-based monomer having the reactive functional group (X) that is reactive with the reactive functional group (Y), and the acrylic-based monomer without the reactive functional group (X), a commercially available product that is a mixture of these monomers (the base resin of "CIELUSTER MK" manufactured by Nippon Paint Co., Ltd.) was used (commonly in Embodiments 1 to 4).

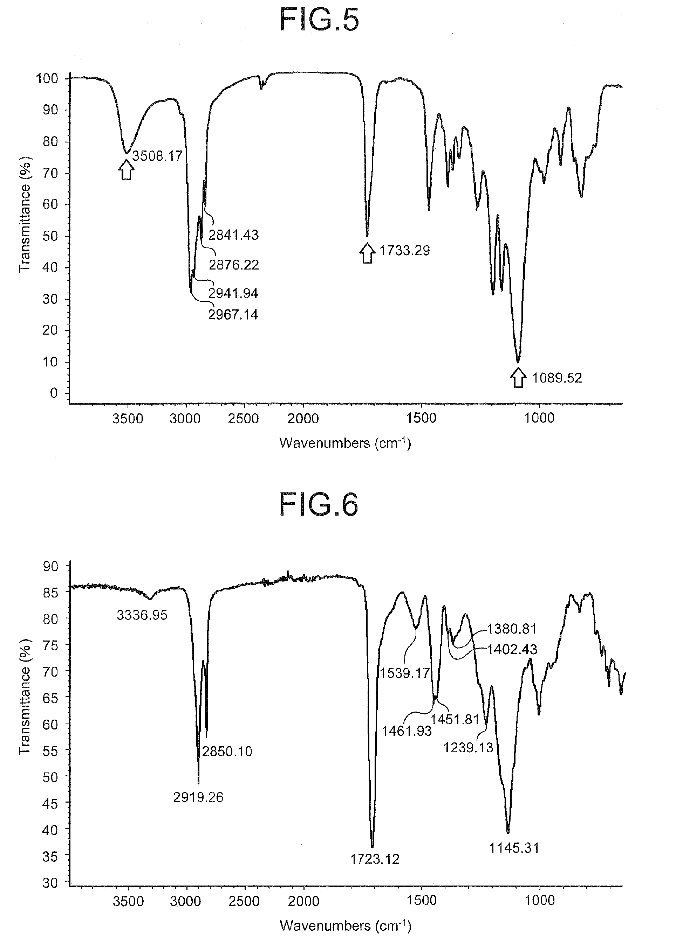

The fact that the aforementioned commercially available product is the mixture of the acrylic-based monomer having the reactive functional group (X) and the acrylic-based monomer without the reactive functional group (X) can be confirmed by the infrared total reflection absorption spectrum of a surface of the dried coating film of the product. The infrared total reflection absorption spectrum is illustrated in FIG. 5.

As illustrated in FIG. 5, typical peaks appear in wave numbers from 3650 to 3200 (cm⁻¹), from 1760 to 1715 (cm⁻¹), and from 1150 to 1025 (cm⁻¹). These peaks respectively correspond to the absorption derived from an OH group of a unit including a carboxylic acid (COOH group) or a hydroxyl group (OH) of the acrylic-based monomer having the reactive functional group (X), the absorption derived from C=O of a unit including ester (COOR) of the acrylic-based monomer without the reactive functional group (X), and the absorption derived from C-O-C of a unit including ester (COOR) or ether (COC) of the acrylic-based monomer without the reactive functional group (X).

Further, in the following Embodiments, "AQUATEK 909" (a name of a product, manufactured by CHIRIKA Co., Ltd.) was used as the ethylene-based resin component B.

### (Embodiment 1)

In Embodiment 1 of the present invention, 100 parts by weight of the aqueous emulsion A obtained by adding 3-glycidoxypropyl triethoxysilane (1 part by weight) to 15 parts by weight of CIELUSTER MK as the acrylic-based resin component A was added with 35 parts by weight of the aqueous emulsion B obtained by adding the ethylene-based resin component "AQUATEC 909" (45% by weight) as the ethylene-based resin component B to prepare a liquid.

As described later (in Table 2), a polyethylene terephthalate (PET) film having a thickness of 125 µm (a product name: "ESTER FILM 5000", manufactured by Toyobo Co., Ltd.) was used as the base material film.

The liquid was applied on both surfaces of the base material film, and the coating film was heated at 80°C for 10 minutes so as to evaporate the water-based solvent and dry the coating film.
The resulting dried coating film was heated at 100°C for 10 minutes so as to polymerize the unreacted monomers that had constituted the coating film, so that the copolymer layer (coating layer) consisting of the acrylic-based copolymer and the ethylene-based copolymer was obtained. The thickness of the resulting film was 20 µm.
According to the above processes, a sheet (that is, a base material for a solar cell module) formed by layering of a coating layer (that is, copolymer layer) with thickness of 20 µm on both surfaces of a base material film with thickness of 125 µm was obtained.

The infrared total reflection absorption spectrum of the copolymer layer is illustrated in FIG. 6. As illustrated in FIG. 6, representative peaks of an acrylic-based copolymer appear in wave numbers from 3690 to 3200 (cm⁻¹), from 1760 to 1715 (cm⁻¹), from 1150 to 1025 (cm⁻¹), and from 1100 to 1000 (cm⁻¹). Further, with regard to the ethylene-based copolymer, representative peaks appear in wave numbers from 2845 to 265 (cm⁻¹) and 2940 to 2915 (cm⁻¹) for methylene (-CH₂-), in wave numbers from 1650 to 1725 (cm⁻¹) for C=O, in wave numbers from 1280 (cm⁻¹) to 1320 for C-O, and in wave numbers from 2500 to 3600 (cm⁻¹) for an unreacted remaining carboxylic acid (-COOH).

It was also possible to confirm by the scanning type electron microscopy that the acrylic-based copolymer forms a sea phase and the ethylene-based copolymer forms an island phase.

First, the peak in the range from 3690 to 3200 (cm⁻¹) corresponds to the absorption derived from OH of a unit including the carboxylic acid (COOH group) or the hydroxyl group (OH) of the acrylic-based monomer having the reactive functional group (X), and OH of a unit including a silanol group (Si-OH) of an alkoxysilane monomer or the hydroxyl group (OH) produced by a ring-opening reaction of an epoxy group. The peak in the range from 1760 to 1715 (cm⁻¹) corresponds to the absorption derived from C=O of a unit including ester (COOR) of the acrylic-based monomer without the reactive functional group (X). The peak in the range from 1150 to 1025 (cm⁻¹) corresponds to the absorption derived from C-O-C of a unit including ester (COOR) or ether (COC) of the acrylic-based monomer without the reactive functional group (X). The peak in the range from 1100 to 1000 (cm⁻¹) corresponds to the absorption derived from Si-O-Si of a unit including a siloxane bond (Si-O) produced by a dehydration-condensation reaction between the silanol groups of the alkoxysilane monomer.

Further, the peak in the range from 2845 to 265 (cm⁻¹) and 2940 to 2915 (cm⁻¹) corresponds to the absorption derived from methylene (-CH₂-) constituting the ethylene-based resin component B, and the peaks in the range of 1650 to 1725 (cm⁻¹) for C=O, 1280 to 1320 (cm⁻¹) for C-O, and 2500 to 3600 (cm⁻¹) correspond to the absorption derived from unreacted remaining carboxylic acid (-COOH) constituting the ethylene-based resin component B.

### (Embodiment 2)

In Embodiment 2 of the present invention, as described later (in Table 2), a multilayered film was used as the base material film. The multilayered film was composed of a polyethylene terephthalate (PET) film having a thickness of 75 µm, and a polyethylene terephthalate (PET) film having a thickness of 12 µm having a vapor deposited layer formed thereon of silicon oxide or aluminum oxide with a thickness of several tens of nanometers ("Ecosyal VE500" a name of a product manufactured by Toyobo Co., Ltd.) that are bonded with an alkoxysilane (3-methacryloxypropyl triethoxysilane) adhesive layer having a thickness of 5 µm. As the liquid, a liquid that is the same as the one used in Embodiment 1 was prepared.

The liquid was applied on both surfaces of the base material film, and the coating film was heated at 80°C for 10 minutes so as to evaporate the water-based solvent and dry the coating film.
The resulting dried coating film was heated at 100°C for 10 minutes so as to polymerize the unreacted monomers that had constituted the coating film, so that the copolymer layer (coating layer) was obtained. The thickness of the resulting film was 20 µm.
The aforementioned process gave a sheet (a base material for a solar cell module) that was obtained by layering the coating layers (copolymer layer) having a thickness of 20 µm on both surfaces of the base material film having a thickness of 92 µm.

The infrared total reflection absorption spectrum of the copolymer layer was taken and it was found out to be the same as the spectrum of FIG. 6.

### (Embodiment 3)

In Embodiment 3 of the present invention, as described later (in Table 2), a multilayered film was used as the base material film. The multilayered film was composed of a polyethylene terephthalate (PET) film having a thickness of 75 µm, and a polyethylene terephthalate (PET) film having a thickness of 50 µm that are bonded with an alkoxysilane (3-methacryloxypropyl triethoxysilane) adhesive layer having a thickness of 5 µm. As the liquid, a liquid that is the same as the one used in Embodiment 1 was prepared.

The liquid was applied on both surfaces of the base material film, and the coating film was heated at 80°C for 10 minutes so as to evaporate the water-based solvent and dry the coating film.
The resulting dried coating film was heated at 100°C for 10 minutes so as to polymerize the unreacted monomers that had constituted the coating film, so that the copolymer layer (coating layer) was obtained. The thickness of the resulting film was 20 µm.
The aforementioned process gave a sheet (a base material for a solar cell module) that was obtained by layering the coating layers (copolymer layer) having a thickness of 20 µm on both surfaces of the base material film having a thickness of 130 µm.

The infrared total reflection absorption spectrum of the copolymer layer was taken and it was found out to be the same as the spectrum of FIG. 6.

### (Embodiment 4)

In Embodiment 4 of the present invention, as described later (in Table 2), a polyethylene terephthalate (PET) film having a thickness of 125 µm was prepared as the base material film.
100 parts by weight of the aqueous emulsion A obtained by adding 3-isocyanatepropyl triethoxysilane (1 part by weight) to 15 parts by weight of CIELUSTER MK as the acrylic-based resin component A was added with 35 parts by weight of the aqueous emulsion B obtained by adding the ethylene-based resin component "AQUATEC 909" (45% by weight) as the ethylene-based resin component B to prepare a liquid.

The liquid was applied on both surfaces of the base material film, and the coating film was heated at 80°C for 10 minutes so as to evaporate the water-based solvent and dry the coating film.
The resulting dried coating film was heated at 100°C for 10 minutes so as to polymerize the unreacted monomers that had constituted the coating film, so that the copolymer layer (coating layer) was obtained. The thickness of the resulting film was 20 µm.
The aforementioned process gave a sheet (a base material for a solar cell module) that was obtained by layering the coating layers (copolymer layer) having a thickness of 20 µm on both surfaces of the base material film having a thickness of 125 µm.

Since the liquid was prepared in Embodiment 4 by using the acrylic-based resin component A and the ethylene-based resin component B that are the same as those of Embodiment 1, the infrared total reflection absorption spectrum of the copolymer layer obtained was found out to be almost the same as the spectrum of FIG. 6.
Specifically, according to the infrared total reflection absorption spectrum of the copolymer layer obtained, representative peaks appear in wave numbers from 3450 to 3200 (cm⁻¹), from 1760 to 1690 (cm⁻¹), from 1150 to 1025 (cm⁻¹), and from 1100 to 1000 (cm⁻¹).

Further, with regard to the ethylene-based copolymer, representative peaks appear in wave numbers from 2845 to 265 (cm⁻¹) and 2940 to 2915 (cm⁻¹) for methylene (-CH₂-), in wave numbers from 1650 to 1725 (cm⁻¹) for C=O, in wave numbers from 1280 (cm⁻¹) to 1320 for C-O, and in wave numbers from 2500 to 3600 (cm⁻¹) for an unreacted remaining carboxylic acid (-COOH).

It was also possible to confirm by the scanning type electron microscopy that the acrylic-based copolymer forms a sea phase and the ethylene-based copolymer forms an island phase.

First, the peak in the range from 3450 to 3200 (cm⁻¹) corresponds to the absorption derived from NH of a unit including an urethane bond that is produced by the reaction of an isocyanate group (NCO) of the alkoxysilane monomer having the reactive functional group (Y) with the hydroxyl group (OH) of the acrylic-based monomer having the reactive functional group (X). The peak in the range from 1760 to 1690 (cm⁻¹) corresponds to the absorption derived from C=O of a unit including ester (COOR) of the acrylic-based monomer without the reactive functional group (X), and C=O of a unit including the urethane bond produced by the reaction of the isocyanate group of the alkoxysilane monomer having the reactive functional group (Y) with the OH group of the acrylic-based monomer having the reactive functional group (X). The peak in the range from 1150 to 1025 (cm⁻¹) corresponds to the absorption derived from C-O-C of a unit including ester (COOR) or ether (COC) of the acrylic-based monomer without the reactive functional group (X). The peak in the range from 1100 to 1000 (cm⁻¹) corresponds to the absorption derived from Si-O-Si of a unit including the siloxane bond (Si-O) produced by the dehydration-condensation reaction between the silanol groups of the alkoxysilane monomer.

Further, the peak in the range from 2845 to 265 (cm-1) and 2940 to 2915 (cm⁻¹) corresponds to the absorption derived from methylene (-CH₂-) constituting the ethylene-based resin component B, and the peaks in the range of 1650 to 1725 (cm⁻¹) for C=O, 1280 to 1320 (cm⁻¹) for C-O, and 2500 to 3600 (cm⁻¹) correspond to the absorption derived from unreacted remaining carboxylic acid (-COOH) constituting the ethylene-based resin component B.

### (Comparative Example 1)

As Comparative Example 1, a commercially available solar cell rear surface protection sheet was used. As described later (in Table 3), the sheet of Comparative Example 1 was composed of a layered film (base material) and fluorine resin films (PVF) having a thickness of 25 µm bonded on both surfaces of the layered film with an adhesive, and the layered film was composed of a PET film having a thickness of 125 µm and, as a gas barrier layer, a SiO₂ vapor deposited film formed on one surface of the PET film with a thickness of 20 nm.

### (Evaluation)

As performance evaluations of the base material for a solar cell module of Embodiments 1 to 4 and Comparative Example 1, water vapor permeation amounts, tensile strength retention ratio, insulation withstand voltage, and peel off strength relative to polyethylene-based sealant were measured before and after ultraviolet ray irradiation by a sunshine carbon arc lamp weather tester ("WEL-300L", a name of a product manufactured by Suga Test Instruments Co., Ltd.). In addition, the water vapor permeation amounts, the tensile strength retention ratio, the insulation withstand voltage, and the peel off strength relative to polyethylene-based sealant were measured before and after an R bending (flexibility) endurance test as described in the following. The results are illustrated in Tables 2 and 3.

### (R bending (flexibility) endurance test)

From a sheet-like sample (A4 size) produced by the aforementioned manner, a piece of the sheet having a size of 15 cm x 15 cm square is cut out. Both edges of the cutout sheet opposing each other are held and thereafter the center portion thereof is bent such that both ends are brought into contact with each other, that is, R bending. This bending is repeated 100 times.

The water vapor permeation amount was measured by the cup method in accordance with JIS Z0208 under the conditions of temperature at 40°C, and humidity at 90% RH. The tensile strength was measured in accordance with JIS K7127 using a universal testing machine (a product name "UH-500kNI") manufactured by Shimadzu Corporation.

The peel off strength relative to the polyethylene-based sealant was performed as follows. First, as the polyethylene-based sealant, low density polyethylene (a product name: ULT-SEX, manufactured by Mitsui Chemicals, Incorporated, a sheet with thickness of 1 mm) was used. On the sealant sheet, each base material sample for a solar cell module of Embodiments 1 to 4 and Comparative Example 1 was layered and adhered by pressing for 20 min at 150°C with pressure of 1 kg/cm. The peel strength relative to the sealant sheet was measured for each sample by using INSTRON 55R4204 type tester manufactured by Instron with reference to JISC2151. The measurement was performed before and after the ultraviolet ray irradiation and also before and after the R bending endurance test.

**Table 2**

| Items for evaluation | | Embodiment 1 | Embodiment 2 | Embodiment 3 |
|---|---|---|---|---|
| Structure of layered body | | Copolymer layer (20 µm)/PET (125 µm)/ Copolymer layer (20 µm) | Copolymer layer (20 µm)/ PET (75 µm)/ Alkoxysilane based adhesives (5 µm) /Si02 vapor deposit layer /PET (12 µm) /Copolymer layer (20 µm) | Copolymer layer (20 µm)/ PET (75 µm) / Alkoxysilane based adhesives (5 m) / PET (50 µm)/ Copolymer layer (20 µm) |
| Initial characteristics | Water vapor permeation amount (g/m²·24h) | 0.86 | 0.01 | 1.35 |
| | Tensile strength retention ratio (%) | 100 | 100 | 100 |
| | Insulation withstand voltage (kV) | 10 or more | 10 or more | 10 or more |
| | Peel off strength relative to polyethylene-based sealant (N/cm) | 23 | 26 | 26 |
| After R bending endurance test | Water vapor permeation amount (g/m²·24h) | 0.88 | 0.02 | 1.45 |
| | Tensile strength retention ratio (%) | 100 | 100 | 100 |
| | Insulation withstand voltage (kV) | 10 or more | 10 or more | 10 or more |
| | Peel off strength relative to polyethylene-based sealant (N/cm) | 21 | 23 | 22 |
| Water vapor permeation amount after anti-weathering property test (after 1000 h) | Water vapor permeation amount (g/m²·24h) | 0.96 | 0.01 | 1.87 |
| | Tensile strength retention ratio (%) | 97 | 97 | 98 |
| | Insulation withstand voltage (kV) | 10 or more | 10 or more | 10 or more |
| | Peel off strength relative to polyethylene-based sealant (N/cm) | 20 | 21 | 23 |

**Table 3**

| Items for evaluation | | Embodiment 4 | Comparative Example 1 |
|---|---|---|---|
| | | Copolymer layer (20 µm)/ PET (125 µm) /Copolymer layer (20 µm) | PVF (20 µm) /PET (125 µm) / SiO2 vapor deposit layer (0.2 µm) / PET (12 µm) / PVF (25 µm) |
| Initial characteristics | Water vapor permeation amount (g/m²·24h) | 0.73 | 0.99 |
| | Tensile strength retention ratio (%) | 100 | 100 |
| | Insulation withstand voltage (kV) | 10 or more | 10 or more |
| | Peel off strength relative to polyethylene-based sealant (N/cm) | 25 | 0.1 |
| After R bending endurance test | Water vapor permeation amount (g/m²·24h) | 0.72 | 3.25 |
| | Tensile strength retention ratio (%) | 100 | 100 |
| | Insulation withstand voltage (kV) | 10 or more | 10 or more |
| | Peel off strength relative to polyethylene-based sealant (N/cm) | 24 | 0.1 or less |
| Water vapor permeation amount after anti-weathering property test (after 1000 h) | Water vapor permeation amount (g/m²·24h) | 0.74 | 2.02 |
| | Tensile strength retention ratio (%) | 99 | 65 |
| | Insulation withstand voltage (kV) | 10 or more | 10 or more |
| | Peel off strength relative to polyethylene-based sealant (N/cm) | 22 | 0.1 or less |

The initial water vapor barrier properties of the base materials of Embodiments 1, 3, and 4 were nearly equal to that of the sheet of Comparative Example 1 using the oxide vapor deposited film. The sheet of Example 2 had a very good initial water vapor barrier property. As for the rupture strength after 1000 hours of ultraviolet ray irradiation, the tensile strength retention ratio of the sheet of Comparative Example 1 deteriorated by about 35%, in spite that the sheet had the fluorine resin film perceived to have an excellent anti-weathering property. In contrast, the tensile strength retention ratio of the sheets of Embodiments 1 to 4 remained almost unchanged even after 1000 hours of ultraviolet ray irradiation.

The water vapor gas barrier property of the sheet of Comparative Example 1 deteriorated after 1000 hours of ultraviolet ray irradiation. On the other hand, the sheets of Embodiments 2 and 4 maintained the initial state, and the sheets of Embodiments 1 and 3 also maintained good values. In the sheets of Embodiments 1 to 4, it is believed that the metal alkoxides absorbed humidity in the air or moisture in the polymer and were hydrolyzed, enhancing the formation of the mesh structure of the M-O bond. As a result, the sheets maintained rupture strengths and the water vapor barrier properties even after 1000 hours of ultraviolet ray irradiation.

Further, the initial value of the peel strength of the base material of Embodiments 1 to 4 relative to the polyethylene-based sealant was significantly higher than the sheet of Comparative example 1 in which an oxide vapor deposit film is used. This is believed due to the fact that the ethylene-based copolymer in particle phase is micro structurally present in the coating layer of the base material and the coating layer of the base material is strongly bonded to the ethylene-based sealant via the ethylene-based copolymer particles. The peel off strength of the base material of Embodiments 1 to 4 relative to the polyethylene-based sealant is maintained at almost the same level even after the ultraviolet ray irradiation and also the R bending endurance test.

### Reference Signs List

- 1: BASE MATERIAL FILM
- 2: COATING LAYER

## Claims

1. A base material for a solar cell module comprising:
a base material film including at least one layer; and
a coating layer including at least one layer formed on one surface or both surfaces of the base material film,
wherein the coating layer is a copolymer layer obtained by curing a liquid coating film comprising an acrylic-based resin component A which comprises metal alkoxide having a reactive functional group (Y), an acrylic-based monomer having a reactive functional group (X) that reacts with the reactive functional group (Y), and an acrylic-based monomer without the reactive functional group (X); and an ethylene-based resin component B comprising a carboxyl group binding to the reactive functional group (Y) of metal alkoxide and including an ethylene monomer b1, a vinyl acetate monomer b2, and a monomer b3 of carboxylic acid vinyl esters other than vinyl acetate.

2. The base material for the solar cell module according to claim 1, wherein the metal alkoxide is a compound represented by the general formula YM(OR)₃, YRM(OR)₂, or YR₂M(OR) (in the formulae, M represents a metal, R represents an alkyl group, and Y represents an ureido group or an isocyanate group).

3. The base material for the solar cell module according to claim 1 or 2, wherein the addition amount of the ethylene-based resin component B is 1 to 99 parts by weight per 100 parts by weight of the acrylic-based resin component A.

4. The base material for the solar cell module according to any one of claims 1 to 3, wherein the base material film is a layered film obtained by layering two or more films with an aid of silane based adhesives.

5. The base material for the solar cell module according to any one of claims 1 to 3, wherein the base material film comprises a single layer and the single layer is a film attached with inorganic oxide vapor deposited film.

6. The base material for the solar cell module according to any one of claims 1 to 4, wherein the base material film comprises at least two layers and at least one layer of them is a film attached with inorganic oxide vapor deposited film.

7. The base material for the solar cell module according to any one of claims 1 to 6, wherein the material of the base material film is one or more kinds selected from a polyester resin, a polyolefin resin, a polystyrene resin, a polyamide resin, a polycarbonate resin, and a polyacrylonitrile resin.

8. The base material for the solar cell module according to any one of claims 1 to 7, wherein an ultraviolet scattering agent or/and an ultraviolet absorbing agent is admixed in a single layer when the coating layer has a constitution of a single layer or in at least one layer when the coating layer has a multilayer constitution.

9. A method for producing a base material for a solar cell module comprising:
preparing a base material film including at least one layer,
preparing a liquid containing acrylic-based resin component A which includes metal alkoxide having a reactive functional group (Y), an acrylic-based monomer having a reactive functional group (X) that reacts with the reactive functional group (Y), and an acrylic-based monomer without the reactive functional group (X); and ethylene-based resin component B which has a carboxyl group binding to the reactive functional group (Y) of metal alkoxide and includes an ethylene monomer b1, a vinyl acetate monomer b2, and a monomer b3 of carboxylic acid vinyl esters other than vinyl acetate,
forming at least one coating film by coating the liquid on one surface or two surfaces of the base material film, and
forming a coating layer comprising at least one copolymer layer by curing at least one coating film described above.

10. The method for producing the base material for the solar cell module according to claim 9, wherein the metal alkoxide is a compound represented by the general formula YM(OR)₃, YRM(OR)₂, or YR₂M(OR) (in the formulae, M represents a metal, R represents an alkyl group, and Y represents an ureido group or an isocyanate group).

11. The method for producing the base material for the solar cell module according to claim 9 or 10, wherein the addition amount of the ethylene-based resin component B is 1 to 99 parts by weight per 100 parts by weight of the acrylic-based resin component A.

12. The method for producing the base material for the solar cell module according to any one of claims 9 to 11, wherein an ultraviolet scattering agent or/and an ultraviolet absorbing agent is admixed, during the preparing of a liquid, in a liquid for constituting a single layer when the copolymer layer has a constitution of a single layer or in a liquid for constituting at least one layer when the copolymer layer has a multilayer constitution.
